# EUROPÄISCHE PATENTSCHRIFT

(11) **EP 2 070 057 B1**
(45) Veröffentlichungstag und Bekanntmachung des Hinweises auf die Patenterteilung: **01.01.2020**
(21) Anmeldenummer: 07818229.2
(22) Anmeldetag: 18.09.2007
(51) Int. Cl.: G07D 7/00, H01L 31/00, H01L 33/00

(54) **SENSOR ZUR UNTERSUCHUNG EINES WERTDOKUMENTS UND VERFAHREN ZUR HERSTELLUNG DES SENSORS**
SENSOR FOR EXAMINING A VALUE DOCUMENT, AND METHOD FOR THE PRODUCTION OF SAID SENSOR
DÉTECTEUR DESTINÉ À L'EXAMEN D'UN DOCUMENT DE VALEUR ET PROCÉDÉ DE FABRICATION DUDIT DÉTECTEUR

(30) Priorität: 19.09.2006 DE 102006043882
(43) Veröffentlichungstag der Anmeldung: 17.06.2009
(73) Patentinhaber: Giesecke+Devrient Currency Technology GmbH, 81677 München (DE)
(72) Erfinder: DOMKE, Jan, 80797 München (DE); MOOSLER, Hans-Uwe, 81929 München (DE); LOHNER, Joseph, 81549 München (DE)
(86) Internationale Anmeldenummer: PCT/EP2007/008127
(87) Internationale Veröffentlichungsnummer: WO 2008/034590

(56) Entgegenhaltungen:
- WO-A-02/18150
- WO-A-2004/068447
- WO-A-2005/048358
- DE-A1- 10 122 563
- DE-A1- 19 844 447
- US-A1- 2004 245 590

## Beschreibung

Die vorliegende Erfindung betrifft einen Sensor zur Untersuchung eines Wertdokuments sowie ein Verfahren zur Herstellung des Sensors.

Unter Wertdokumenten werden dabei blattförmige Gegenstände verstanden, die beispielsweise einen monetären Wert oder eine Berechtigung repräsentieren und daher nicht beliebig durch Unbefugte herstellbar sein sollen. Sie weisen daher nicht einfach herzustellende, insbesondere zu kopierende Merkmale auf, deren Vorhandensein ein Indiz für die Echtheit, d.h. die Herstellung durch eine dazu befugten Stelle, ist. Wichtige Beispiele für solche Wertdokumente sind Chipkarten, Coupons, Gutscheine, Schecks und insbesondere Banknoten.

Solche Wertdokumente sollen in vielen Fällen auf ihre Echtheit und/oder ihren physischen Zustand, beispielsweise die Lappigkeit oder das Vorhandensein von Rissen, Löchern oder Klebestreifen, maschinell untersucht werden.

Hierzu werden in Vorrichtungen zur Bearbeitung von Wertdokumenten Sensoren zur Untersuchung der Wertdokumente eingesetzt, unter denen im Rahmen der vorliegenden Erfindung Einrichtungen zur Erfassung wenigstens einer Eigenschaft wenigstens eines Abschnitts eines Wertdokuments und zur Bildung die Eigenschaft wiedergebender Sensorsignale verstanden werden. Diese Sensoren brauchen dabei nicht unbedingt eine Schaltung zur Verarbeitung der Detektionssignale oder zur Ansteuerung zu enthalten.

Diese Sensoren verfügen typischerweise über wenigstens ein elektrisches Bauteil, das dazu dient, elektrische Energie in Schallwellen und/oder magnetische oder elektromagnetische Felder, insbesondere optische Strahlung, zur Untersuchung des Wertdokuments umzuwandeln und/oder Schallwellen und/oder magnetische oder elektromagnetische Felder, insbesondere optische Strahlung, von dem Wertdokument unter Bildung von Detektionssignalen zu erfassen bzw. detektieren. Im ersten Fall umfaßt der Sensor meist noch ein Detektionselement zur Erfassung durch Einwirkung der Schallwellen und/oder magnetische bzw. elektromagnetischen Felder ausgelöster Effekte. Zur Versorgung mit elektrischer Energie bzw. zum Austausch von Signalen sind die Bauteile in der Regel mit einer Leiterplatte verbunden, auf der sich Steckverbinderkontakte für ein zu einer elektrischen Auswerteschaltung führendes Verbindungskabel mit einem komplementären Steckverbinder befindet. Das jeweilige Bauteil ist in der Regel in einem Halter in einer für die Untersuchung von Wertdokumenten günstigen Lage gehalten und über Kabel mit der separaten Leiterplatte verbunden.

Da solche Sensoren häufig in Vorrichtungen zur automatischen Bearbeitung von Wertdokumenten verwendet werden, sollen diese möglichst klein und mit nur geringem Aufwand herzustellen sein. Der oben geschilderte Aufbau eines Sensors erfordert jedoch einige Montageschritte und benötigt auch nicht unerheblichen Platz.

In US 2004/0245590 A1 ist ein Bildsensorpackage beschrieben, das mehrere Leiterrahmen, ein geformtes Harz, einen photosensitiven Chip, mehrere Drähte und eine transparente Schicht umfaßt. Jeder der Leiterrahmen besitzt ein erste Platte und eine zweite Platte, die sich auf einer anderen Höhe befindet als die erste Platte, und eine Kammer ist über der Mitte der Leiterahmen ausgebildet. Das geformte Harz dient zur Kapselung der Leiterrahmen und bildet eine obere und eine untere Oberfläche, wobei die ersten Platten der Leiterrahmen an der oberen Oberfläche freiliegen. Der photosensitive Chip ist auf der oberen Oberfläche des geformten Harzes befestigt innerhalb der Kammer angeordnet. Jeder der Drähte verbindet den photosensitiven Chip elektrisch mit jeder der zweiten Platte der mehreren Leiterrahmen.

In WO 2004/068447A1 ist ein Optikelement beschrieben, das zumeist in einer beliebig angeordneten Vielzahl in im wesentlichen senkrecht angeordneten Frontflächen von Wechselverkehrszeichen zur Darstellung von Symbolen oder grafischen Informationen einsetzbar ist. Es besteht aus zumindest einer ansteuerbaren Lichtquelle, zumeist einer LED, welche auf einer Platine sitzen kann, einem Linsenelement mit Lichteintrittsfläche, Mantelfläche und Austrittsfläche und vorzugsweise einem zumindest einen Teil der Mantelfläche umgebenden Gehäuse, mit im wesentlichen horizontaler bis abwärts geneigter Lichtabstrahlung, wobei die Mantelfläche eine maximal Licht schluckende Absorptionsfläche aufweist. Die Absorptionsfläche grenzt unmittelbar an die Lichteintritts- und Austrittsfläche des Linsenelementes an. Die Länge des Linsenelementes ist größer als sein Durchmesser und die Krümmung der Austrittsfläche ist an jedem Flächenpunkt so ausgebildet, daß im wesentlichen alle von der Lichtquelle kommenden Lichtstrahlen in einem Bereich unterhalb eines festgelegten Winkels, vorzugsweise kleiner oder gleich 10°, bezüglich der Horizontalen und im wesentlichen alle von außen mit einem Winkel größer oder gleich S bezüglich der Horizontalen einfallenden Lichtstrahlen auf die Absorptionsfläche gelenkt werden.

In WO 2005/048358 A1 ist eine Leuchtdioden-Anordnung beschrieben, die wenigstens einen Leuchtdioden-Chip, eine Mehrschicht-Platine mit einer Basis aus einem thermisch gut leitfähigen Material, insbesondere aus Metall, und eine elektrisch isolierende und thermisch leitende Verbindungsschicht zwischen der Emissionsfläche des Leuchtdioden-Chips und der Platine umfaßt.

DE 198 444 47 A1 beschreibt eine Vorrichtung zur Prüfung von Blattgut, insbesondere Banknoten, umfassend eine Einrichtung zum Transport des Blattguts in einer definierten Richtung, wenigstens ein Schallwandlerpaar mit einem Sender, der das Blattgut mit Schallwellen beaufschlagt und einem Empfänger, der den durch das Blattgut transmittierten Schallanteil detektiert, wobei Sender und Empfänger in bezug auf die Transportebene schräg zueinander angeordnet sind.

Der vorliegenden Erfindung liegt daher die Aufgabe zugrunde, einen Sensor zur Untersuchung eines Wertdokuments zu schaffen, der eine einfache und kompakte Bauform zuläßt, und ein entsprechendes Verfahren zu dessen Herstellung bereitzustellen.

Die Aufgabe wird gelöst durch einen Sensor zur Untersuchung eines Wertdokuments in einem Erfassungsbereich des Sensors mit den Merkmalen des Anspruchs 1. Der Sensor weist insbesondere wenigstens ein elekt-risches Bauteil zur Wandlung elektrischer Energie in Schallwellen zur Untersuchung des Wertdokuments und/oder zur Detektion von Schallwellen von dem Wertdokument unter Bildung von Detektionssignalen, und einen Halter für das Bauteil auf, der eine Ausnehmung oder ein Loch zur wenigstens teilweisen Aufnahme des Bauteils aufweist, in der das elektrische Bauteil gehalten ist, und auf oder in dem sich wenigstens eine Leiterbahn erstreckt, mit der wenigstens ein elektrischer Kontakt des elektrischen Bauteils kontaktiert ist.

Die Aufgabe wird weiter gelöst durch ein Verfahren zur Montage eines elektrischen Bauteils zur Wandlung elektrischer Energie in Schallwellen zur Untersuchung des Wertdokuments und/oder zur Detektion von Schallwellen von dem Wertdokument unter Bildung von Detektionssignalen, in einem Loch in einem Halter mit den Merkmalen nach Anspruch 16. Insbesondere wird bei dem Verfahren das Bauteil wenigstens teilweise in das Loch eingebracht und wenigstens ein elektrischer Kontakt des elektrischen Bauteils wird mit einer Leiterbahn auf oder in dem Halter kontaktiert.

Bevorzugte Ausführungsformen und Weiterbildungen sind in der Beschreibung, den Ansprüchen und den Zeichnungen beschrieben.

Bei dem elektrischen Bauteil kann es sich insbesondere um ein Abstrahlelement für Schallwellen oder um ein entsprechendes Empfangselement handeln.

Der erfindungsgemäße Sensor zeichnet sich insbesondere durch den Halter aus, der wenigstens zwei Funktionen gleichzeitig erfüllt: zum einen dient er zur Halterung des wenigstens einen Bauteils, zum anderen stellt er wenigstens eine Kontaktierung für das Bauteil dar, so daß neben einem Halter für das Bauteil keine zusätzliche Leiterplatte notwendig ist. Dies erlaubt einen sehr kompakten Aufbau und gleichzeitig durch die reduzierte Anzahl von Teilen auch eine vereinfachte Montage. Die Leiterbahn kann insbesondere mit einem Steckverbinder verbunden sein, über den das Bauteil oder der ganze Sensor mit externen Einheiten verbunden werden kann.

Weiter ist das Bauteil wenigstens teilweise in dem Loch in dem Halter angeordnet, insbesondere also teilweise darin versenkt. Darunter wird verstanden, daß wenigstens ein Abschnitt des Bauteils, der nicht ausschließlich die Kontaktelemente des Bauteils umfaßt, in dem Loch sitzt. Dies hat den weiteren Vorteil, daß eine stabilere Halterung des Bauteils möglich ist und das Bauteil, insbesondere bei vollständiger Versenkung in dem Loch, besser gegen äußere mechanische Einflüsse geschützt werden kann.

Erfindungsgemäß ist der Halter einstückig ausgebildet. Die einstückige Ausbildung erleichtert insbesondere die Herstellung des Halters. Der Halter braucht bei einstückiger Ausbildung nicht nur eine Schicht zu umfassen, sondern kann auch einen Mehrschichtaufbau aufweisen.

Der Halter kann prinzipiell aus beliebigen Materialien hergestellt werden, mittels derer die funktionellen Anforderungen an den Halter erfüllbar sind. Vorzugsweise ist das Material in Verbindung mit der Form des Halters so gewählt, daß der Halter starr ist, d.h. sich bei Angriff von im normalen Gebrauch auftretenden nicht oder nur sehr gering verformt.

In einer sehr einfachen Variante kann der Halter vernetzte Polymerwerkstoffen, insbesondere Harze, oder Verbundmaterialien daraus umfassen. So können beispielsweise klassische Platinen, insbesondere mit Dicken zwischen 2 mm und 10 mm, vorzugsweise 4 mm und 8 mm, beispielsweise aus Pertinax oder mit Epoxidharz getränkten Glasfasermatten bzw. mit Glasfasermatten verstärktem Epoxidharz (zum Beispiel FR4), verwendet werden. Solche Halter können sehr einfach mit klassischen Materialbearbeitungsverfahren wie beispielsweise Fräsen und/oder Bohren bearbeitet werden.

Bei einer anderen bevorzugten Ausführungsform umfaßt der Halter wenigstens eine Schicht eines keramischen Materials. Die Verwendung von keramischen Materialien bietet den Vorteil, daß diese hoch wärmebeständig sind, und eine gute mechanische Stabilität zeigen. Vorzugsweise wird als keramisches Material ein gut wärmeleitendes Material, beispielsweise Aluminiumoxid, oder ein hochwärmeleitendes Material, beispielsweise Aluminiumnitrid, verwendet. Dadurch kann gegebenenfalls durch das Bauteil erzeugte Wärme gut von diesem abgeführt werden.

Bei einer bevorzugten Ausführungsform des Sensors ist der Halter ein Spritzguß- oder Spritzpreßteil oder umfaßt wenigstens ein Spritzguß- oder Spritzpreßteil. Bei dem Verfahren wird dementsprechend der Halter unter Verwendung von Spritzgießen oder -pressen hergestellt. Diese Ausführungsform bietet den Vorteil, daß der Halter sehr einfach auch bei komplizierten Geometrien gefertigt werden kann. Eine besonders einfache Herstellung ergibt sich, wenn die Oberfläche des Halters hinterschneidungsfrei ist. Das Spritzgußteil kann insbesondere aus wenigstens einem thermoplastischen Material gefertigt sein. Es sind jedoch auch andere polymere, zum Spitzgie-ßen oder -pressen verwendbare Materialien oder Materialgemische verwendbar. Vorzugsweise werden dabei polymere Materialien verwendet, die auch zur Auf- oder Einbringung der Leiterbahn metallisierbar sind. Als polymere Materialien kommen insbesondere technische Kunststoffe wie beispielsweise Polyamide, Polyester, Polyetherketone, Polyetheretherketone, Polyoxymethylen, flüssigkristalline Polymere oder, insbesondere bei einem optischen Sensor, transparente Polymere wie Polycarbonate, in Betracht.

Der Halter kann grundsätzlich eine beliebige Form aufweisen. Sollen jedoch mehrere Bauteile als Feld angeordnet werden, ist es bevorzugt, daß der Halter in seiner Grundform plattenförmig ausgebildet ist. Das bedeutet insbesondere, daß der Halter als Platte mit wenigstens einem Loch ausgebildet sein kann. Diese Ausführungsform läßt eine besonders einfache Herstellung des Halters aus, insbesondere den oben genannten, Materialien zu.

Prinzipiell kann die Leiterbahn auf einer von zwei sich gegenüberliegenden Oberflächen des Halters ausgebildet sein. Für den Schutz der Leiterbahn ist es jedoch bevorzugt, daß die Leiterbahn auf einer Oberfläche des Halters angeordnet ist, die von dem Wertdokument bei einer Untersuchung abge-wandt ist oder einer Abstrahl- oder Empfangsfläche des Bauteils abgewandt ist. Unter der Abstrahl- oder Empfangsfläche des Bauteils wird dabei die Fläche des Bauteils verstanden, an der bei Abstrahlung die Aus- bzw. bei Empfang die Einkopplung der Wellen bzw. der Feldes in das Bauteil erfolgt.

Soll das Bauteil nur mechanisch geschützt werden, kann es in beliebiger Weise in dem Loch angeordnet sein. Ein besonderer Vorteil ergibt sich jedoch, wenn bei dem Sensor das Bauteil mittels wenigstens eines Oberflächenabschnitts einer das Loch bildenden Wand und/oder einer Ausrichtstruktur der Wand des Halters relativ zu dem Halter ausgerichtet ist. Der Halter kann dann eine dritte Funktion übernehmen, nämlich die Ausrichtung des Bauteils. Leiterplatten nach dem Stand der Technik erlauben es allenfalls, ein Bauteil in einer Fläche anzuordnen, nicht aber, es mit guter Genauigkeit im Raum auszurichten.

Bei dem Oberflächenabschnitt kann es sich um einen glatten Bereich der Oberfläche des Lochs, bei einem zylindrischen Loch einem zylindrischen Abschnitt, handeln, an dem das Bauteil abgestützt ist oder zwischen dem es eingeklemmt oder eingepreßt ist. Eine besonders gute Ausrichtung ist jedoch erzielbar, wenn die Wand des Lochs die Ausrichtstruktur aufweist, mittels derer das Bauteil relativ zu dem Halter ausgerichtet ist. Durch eine solche Ausrichtstruktur kann eine besonders genaue Ausrichtung erfolgen, die beispielsweise im Fall eines zylindrischen Lochs, nicht unbedingt in Richtung der Lochachse zu verlaufen braucht. Weiter können Ausrichtstruktur und Bauteil aufeinander abgestimmt ausgebildet sein, so daß eine besonders gute Passung erzielt werden kann.

Insbesondere können bei dem Sensor der Oberflächenabschnitt bzw. die Ausrichtstruktur und das Bauteil so ausgebildet sein, daß das Bauteil mit einer Hauptabstrahlrichtung oder einer Hauptempfangsrichtung gegenüber der Oberfläche des Halters geneigt ist. Um diese Ausbildung zu ermöglichen, muß das Loch entsprechend ausgebildet sein. Bei Vorhandensein einer Ausrichtstruktur gilt entsprechendes. Diese Ausführungsform ermöglicht trotz der möglichen Einfachheit des Halters eine genaue Ausrichtung des Bauteils relativ zu dem Halter in einer beliebigen Richtung.

Die Ausrichtstruktur kann auf vielfältige Weise ausgebildet sein. So kann sie zum Beispiel ein Führungselement aufweisen, das sowohl die Ausrichtung des Bauteils im Raum als auch eine Drehlage um die Hauptabstrahlrichtung oder die Hauptempfangsrichtung ermöglicht. Beispielsweise kann es sich dabei um eine Schulter, eine Nut oder eine Feder handeln, die sich entlang einer Richtung erstreckt, in der das Bauteil in das Loch eingebracht wird.

Besonders bevorzugt weist die Ausrichtstruktur eine um das Loch umlaufende Schulter oder eine Nut auf. Diese Ausführungsform hat den Vorteil, daß die Schulter bzw. die Nut gleich zwei Funktionen erfüllen kann, nämlich zum einen eine Positionierung in dem Loch einer Richtung, in der das Bauteil in das Loch eingebracht wird, und zum anderen eine Ausrichtung.

Erfindungsgemäß bildet bei dem Sensor das Loch einen sich durch den Halter erstreckenden Kanal. Diese Ausführungsform erlaubt es nämlich, das Bauteil in dem Kanal so anzuordnen, daß es in einer Richtung des Kanals kontaktiert werden kann und in der anderen Richtung abstrahlen bzw. empfangen kann. Insbesondere kann der Kanal durch ein Durchgangsloch durch den Halter gebildet werden.

Für die Herstellung des Halters ist es besonders vorteilhaft, wenn das Loch rotationssymmetrisch um eine in ihrer Lage relativ zu dem Halter vorgegebene Achse ausgebildet ist. Solche Löcher sind nämlich besonders einfach beispielsweise durch Bohren oder Fräsen herstellbar.

Das Loch kann grundsätzlich in beliebiger Form ausgebildet sein. Bei einer besonders bevorzugten Ausführungsform ist das Loch gegenüber einer Oberfläche des Halters geneigt. Dies erlaubt es, das Bauteil besonders einfach und genau in einer ebenfalls gegen die Oberfläche geneigten Lage relativ zu dem Halter anzubringen und auszurichten.

Prinzipiell genügt es, daß das Bauteil wenigstens teilweise in dem Loch angeordnet ist, wobei zwischen den durch das Loch gebildeten Innenfläche des Halters und dem Bauteil Leerräume vorhanden sein können. Insbesondere in dem Fall, daß der elektrische Kontakt des Bauelements in dem Loch angeordnet ist, ist es bei dem Sensor bevorzugt, daß das Bauteil wenigstens teilweise in dem Loch eingebettet oder eingegossen ist. Dies erlaubt eine stabilere Halterung des Bauelements in dem Loch und, bei Auswahl eines geeigneten Einbett- bzw. Eingußmaterials, einen Schutz vor Feuchtigkeit, Ölen oder anderen nachteilig wirkenden Substanzen und Stoffen. Weiter kann ein geeignet gewähltes Material in vorteilhafter Weise so gewählt werden, daß es schwingungsdämpfend wirkt. Eine solche Schwingungsdämpfung ist insbesondere vorteilhaft, wenn das elektrische Bauteil ein elektroakustisches Bauteil wie ein Schallsender oder Schallempfänger ist. Als Eingußmasse kann insbesondere ein flexibles, vorzugsweise elastisches, Material verwendet werden, das dazu geeignet ist, ein Auftreten von Spalten oder Rissen zu vermeiden, die bei temperaturbedingten Änderungen der Ausdehnung des Halters und des Bauteils auftreten. Weiter werden vorzugsweise elektrisch isolierende Einguß- bzw. Einbettmaterialien verwendet. Entsprechende Materialien, beispielsweise Gele, sind dem Fachmann bekannt.

Der Halter kann, wie bereits beschrieben, mehr als eine Schicht außer der Leiterbahn aufweisen. Vorzugsweise ist an einer Oberfläche des Halters oder innerhalb des Halters eine elektrisch leitende Abschirmschicht ausgebildet.

Diese Ausführungsform hat den Vorteil, daß die Abschirmschicht elektromagnetische Felder abschirmen kann, so daß das Bauteil wenigstens teilweise gegen elektromagnetische Störungen aus der Umgebung geschützt werden kann. Damit kann eine Beeinträchtigung der Funktion und insbesondere auch des Signal-/Rausch-Verhältnisses durch äußere elektromagnetische Felder stark reduziert werden. Der Halter übernimmt somit noch eine weitere Funktion. Insbesondere in diesem Fall ist es bevorzugt, daß das Bauteil mit einem gegen elektrische oder elektromagnetische Felder empfindlichen Abschnitt in dem Loch angeordnet ist. Gerade dieser Abschnitt ist dann gut abgeschirmt. Die Abschirmschicht ist vorzugsweise ebenfalls aus einem Metall oder einer Metalllegierung. Weiter kann die Abschirmschicht einen Kontakt aufweisen, mittels dessen die Abschirmschicht mit Erdpotential verbunden werden kann, um die Abschirmwirkung zu verbessern.

In einer besonders bevorzugten Ausführungsform beinhaltet die Abschirmschicht weichmagnetisches Material, so daß auch magnetische Felder abgeschirmt werden können.

Allgemein braucht sich die Abschirmschicht nicht vollflächig über die Oberfläche des Halters zu erstrecken; so ist es möglich, daß in dieser Schicht Aussparungen vorgesehen sind, die jedoch die Abschirmwirkung nicht stark beeinträchtigen sollten.

Das Bauteil umfaßt einen Ultraschallwandler. Der Ultraschallwand ler kann dabei als Sender und/oder Empfänger für Ultraschallwellen dienen. In diesem Fall kann die Anordnung des Wandlers in der Ausnehmung oder dem Loch bei deren geeigneter Ausbildung noch als Nebeneffekt eine bessere Bündelung des abgestrahlten Ultraschalls bewirken.

Der elektrische Kontakt des Bauteils kann prinzipiell in beliebiger Weise direkt oder indirekt elektrisch mit der Leiterbahn kontaktiert sein.

Bei einer bevorzugten Variante ist das Bauteil mittels eines Drahtes mit der Leiterbahn kontaktiert. Hierbei kann es sich um eine einfach Lötverbindung oder eine durch Drahtbonden hergestellte Verbindung handeln. Diese Ausführungsform bietet den Vorteil, daß beispielsweise bei Erwärmung des Sensors auftretende Lage- oder Dimensionsänderungen des Bauteils relativ zu dem Halter durch den Draht einfach ausgeglichen werden können. Weiter sind Bauteile, die mit Drähten kontaktiert werden, sehr leicht erhältlich.

Der Sensor braucht nicht nur ein Bauteil aufzuweisen, das in dem Halter gehalten ist. Vielmehr weist der Sensor bevorzugt ein weiteres Bauteil zur Wandlung elektrischer Energie in Schallwellen zur Untersuchung des Wertdokuments und/oder zur Detektion von Schallwellen, von dem Wertdokument unter Bildung von Detektionssignalen, auf und der Halter besitzt wenigstens ein weiteres Loch, in dem das weitere Bauteil wenigstens teilweise angeordnet ist, sowie eine weitere Leiterbahn, mit der wenigstens ein elektrischer Kontakt des elektrischen Bauteils des weiteren Bauteils kontaktiert ist.

Für den Sensor können dann in Bezug auf das weitere Bauteil und/oder das weitere Loch wenigstens eine oder mehrere der zuvor oder im Folgenden genannten Ausführungsformen in Bezug auf das Bauteil und das Loch übernommen werden, wobei die Ausführungsform in Bezug auf das Bauelement bzw. das Loch sich von der in Bezug auf das weitere Bauelement bzw. das weitere Loch unterscheiden kann. Diese Ausführungsform bietet unter anderem den Vorteil, daß eine Ausrichtung des Bauteils und des weiteren Bauteils zueinander und zu dem Halter in einfacher Weise und sehr genau erfolgen kann. Insbesondere kann erreicht werden, daß eine zusätzliche Justierung der beiden Bauteile aufeinander oder relativ zueinander nicht notwendig ist.

Besonders bevorzugt ist beispielsweise eine Ausführungsform des Sensors bei der das wenigstens eine Bauteil als Sender mit richtungsabhängiger Sendecharakteristik ausgebildet ist, und ein weiteres Bauteil als Empfänger mit richtungsabhängiger Empfangscharakteristik wenigstens teilweise in einem weiteren Loch in dem Halter angeordnet und mit einer weiteren Leiterbahn in oder auf dem Halter kontaktiert ist, wobei die Bauteile so relativ zueinander gehalten sind, daß der Empfänger bei Untersuchung eines Wertdokuments wenigstens näherungsweise die höchste Intensität empfangen kann. Dieser sehr einfach und kompakt aufgebaute Sensor erlaubt Untersuchungen eines Wertdokuments in Remission bzw. Reflexion mit einer hohen Genauigkeit der Ausrichtung.

Prinzipiell braucht der Sensor nur den Halter einschließlich Leiterbahn und das mit der Leiterbahn kontaktierte wenigstens teilweise in dem Loch angeordnete Bauteil aufzuweisen. Vorzugsweise besitzt der Sensor jedoch noch eine elektrische Schaltung zur Ansteuerung des Bauteils oder zur Verarbeitung von Signalen des Sensors. Ein besonders kompakter Aufbau wird erhalten, wenn die elektrische Schaltung zur Ansteuerung des Bauteils oder zur Verarbeitung von Signalen des Bauteils auf dem Halter angeordnet und mit der Leiterbahn verbunden ist. Die Schaltung kann eine analoge oder digitale oder gemischt analog-digitale Schaltung sein, die insbesondere auch einen Mikroprozessor oder -kontroller besitzen kann. Neben der kompakten Bauform ergibt sich durch die sehr kurze Verbindung zwischen Bauteil und Schaltung auch eine besonders geringe Anfälligkeit gegen elektrische oder elektromagnetische Störfelder. Sind in Löchern in dem Halter mehrere Bauteile gleicher Art gehalten, besitzen die Leiterbahnen vorzugsweise jeweils eine Länge, die weniger als 10% von dem Mittelwert über die Längen der Leiterbahnen abweicht. Auf diese Weise können Laufzeitunterschiede für Signale von den Bauteilen einfach reduziert werden. Ein besonders einfacher Aufbau ergibt sich darüber hinaus, wenn die Schaltung auf einem Chip ausgebildet ist.

Eine bevorzugte Weiterbildung des Sensors zeichnet sich dadurch aus, daß der Halter über wenigstens ein Befestigungselement zur Befestigung des Halters an einer Vorrichtung verfügt. Im einfachsten Fall können dies Löcher in einem plattenförmigen Halter sein, es ist jedoch, beispielsweise bei der Ausführung als Spritzgußteil, möglich, daß als Befestigungselement ein Element für eine Schnapp- oder Rastverbindung verwendet wird. Dies hat den Vorteil, daß eine werkzeuglose Montage des Halters einfach möglich ist.

Die erfindungsgemäßen Sensoren können besonders vorteilhaft in Wertdokumentbearbeitungsvorrichtungen eingesetzt werden. Gegenstand der Erfindung ist daher auch eine Wertdokumentbearbeitungsvorrichtung zur Bearbeitung von Wertdokumenten mit einem erfindungsgemäßen Sensor. Vorzugsweise verfügt die Wertdokumentbearbeitungsvorrichtung über eine Transporteinrichtung zum Transport von Wertdokumenten zu dem Sensor, insbesondere in oder durch den Erfassungsbereich des Sensors, und zum Abtransport von Wertdokumenten von dem Sensor, genauer aus dem Erfassungsbereich des Sensors hinaus.

Die Erfindung wird im Folgenden noch näher anhand der Zeichnungen erläutert. Es zeigen:
- Fig. 1: eine schematische Darstellung einer Banknotenbearbeitungsvorrichtung,
- Fig. 2: eine schematische Seitenansicht eines ersten Ultraschallsensors der Banknotenbearbeitungsvorrichtung in Fig. 1,
- Fig. 3: eine schematische Draufsicht auf einen Halter des Ultraschallsensors und darin gehaltenen Ultraschallwandlern,
- Fig. 4: eine schematische Ansicht von unten auf den Halter in Fig. 3,
- Fig. 5: eine schematische Ansicht eines Schnitts durch einen Abschnitt des Halters in Fig. 3 entlang einer Ebene orthogonal auf eine Oberfläche des Halters,
- Fig. 6: eine schematische Ansicht eines Schnitts durch einen Abschnitts eines Halters eines zweiten Ultraschallsensors,
- Fig. 7: eine schematische Draufsicht auf einen Halter eines dritten Ultraschallsensors mit darin gehaltenen Ultraschallwandlern,
- Fig. 8: eine schematische Ansicht eines Schnitts durch einen Abschnitt eines Halters eines vierten Ultraschallsensors,
- Fig. 9: eine schematische Ansicht eines Schnitts durch einen Abschnitt eines Halters eines fünften Ultraschallsensors,
- Fig. 10: eine schematische Darstellung eines Abschnitts eines sechsten Ultraschallsensors,
- Fig. 11: eine schematische Ansicht eines Schnitts durch einen Abschnitt eines Halters des sechsten Ultraschallsensors in Fig. 10, und
- Fig. 12: eine schematische Ansicht eines Schnitts durch einen Abschnitt eines Halters eines weiteren Ultraschallsensors entsprechend Fig. 3.

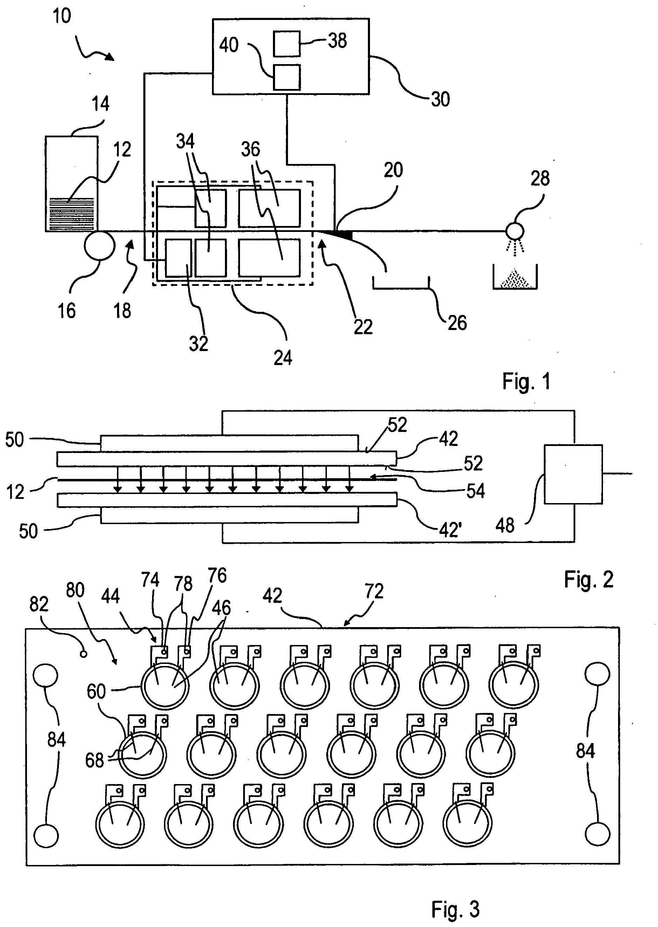

Fig. 1 zeigt eine Vorrichtung 10 zur Bestimmung eines Zustands von Wertdokumenten, im Beispiel eine Banknotenbearbeitungsvorrichtung, die unter anderem zur Ermittlung des Zustands von Wertdokumenten 12 in Form von Banknoten dient. Die Vorrichtung 10 verfügt über ein Eingabefach 14 für die Eingabe von zu bearbeitenden Wertdokumenten 12, einen Vereinzler 16, der auf Wertdokumente 12 in dem Eingabefach 14 zugreifen kann, eine Transporteinrichtung 18 mit einer Weiche 20, und nach der Weiche 20 ein Ausgabefach 26 und einen Schredder 28 zur Vernichtung von Wertdokumenten bzw. Banknoten. Entlang eines durch die Transporteinrichtung 18 gegebenen Transportpfades 22 ist vor der Weiche 20 und nach dem Vereinzler 16 eine Sensoranordnung 24 angeordnet, die zur Erfassung von Eigenschaften vereinzelt zugeführter Wertdokumente 12 und Bildung von die Eigenschaften wiedergebenden Sensorsignalen dient. Eine Steuer- und Auswerteeinrichtung 30 ist wenigstens mit der Sensoranordnung 24 und der Weiche 20 über Signalverbindungen verbunden und dient zur Auswertung von Sensorsignalen der Sensoranordnung 24 und Ansteuerung wenigstens der Weiche 20 in Abhängigkeit von dem Ergebnis der Auswertung der Sensorsignale.

Die Sensoranordnung 24 umfaßt dazu wenigstens einen Sensor; in diesem Ausführungsbeispiel sind drei Sensoren vorgesehen, nämlich ein erster Sensor 32, im Beispiel ein optischer Sensor zur Erfassung farblicher Eigenschaften, der von dem Wertdokument remittierte optische Strahlung erfaßt, ein zweiter Sensor 34, im Beispiel ebenfalls ein optischer Sensor zur Erfassung spezieller spektraler Sicherheitsmerkmale der Wertdokumente, der von dem Wertdokument transmittierte optische Strahlung erfaßt, und ein dritter Sensor 36, im Beispiel ein akustischer Sensor, genauer ein Ultraschallsensor, der von dem Wertdokument stammende, insbesondere transmittierte, Ultraschallsignale erfaßt.

Während des Vorbeitransports eines Wertdokuments 12 erfassen die Sensoren 32, 34 und 36 entsprechend ihrer Funktion Eigenschaften von durch die Relativlage der Sensoren zu dem Wertdokument bestimmten Abtastbereichen auf dem Wertdokument, wobei die entsprechenden Sensorsignale gebildet werden. Jeder der Sensoren kann dabei eine andere räumliche Auflösung aufweisen, d.h. die Größe und Verteilung der erfaßten Abtastbereiche auf dem Wertdokument können in Abhängigkeit von dem jeweiligen Sensor und der verwendeten Transportgeschwindigkeit variieren. Jedem der Abtastbereiche ist dabei ein Ort zugeordnet, der die Lage der Abtastbereiche für den jeweiligen Sensor zueinander und/oder relativ zu dem Wertdokument wiedergibt.

Aus den analogen oder digitalen Sensorsignalen der Sensoren 32, 34, 36 wird von der Steuer- und Auswerteeinrichtung 30 bei einer Sensorsignalauswertung wenigstens eine Eigenschaft wenigstens eines Abtastbereichs und/oder wenigstens eine Wertdokumenteigenschaft ermittelt, die für die Überprüfung der Banknoten in Bezug auf deren Zustand relevant sind. Vorzugsweise werden mehrere dieser Eigenschaften ermittelt. Weiter wird mittels der Signale des Sensors 34 die Echtheit der Wertdokumente überprüft. Die Wertdokumenteigenschaften charakterisieren den Zustand der Wertdokumente, in diesem Beispiel den Zustand der Banknoten in Bezug auf die Verkehrsfähigkeit bzw. Umlauffähigkeit, d.h. die Eignung weiterhin als Zahlungsmittel verwendet werden zu können. Als entsprechende Wertdokumenteigenschaften werden in diesem Beispiel insbesondere das Vorhandensein von Verschmutzungen oder Flecken sowie das Vorhandensein von Rissen, Klebestreifen, Eselsohren und/oder Löchern, und/oder das Fehlen von Bestandteilen der Wertdokumente verwendet. Diese Wertdokumenteigenschaften können in Abhängigkeit von Sensorsignalen nur eines der Sensoren oder wenigstens zweier der Sensoren ermittelt werden.

Die Steuer- und Auswerteeinrichtung 30 verfügt dazu insbesondere neben entsprechenden Schnittstellen für die Sensoren über einen Prozessor 38 und einen mit dem Prozessor 38 verbundenen Speicher 40, in dem wenigstens ein Computerprogramm mit Programmcode gespeichert ist, bei dessen Ausführung der Prozessor 38 die Vorrichtung steuert bzw. die Sensorsignale, insbesondere zur Ermittlung eines Gesamtzustands eines geprüften Wertdokuments, auswertet und entsprechende der Auswertung die Transporteinrichtung 18 ansteuert.

Insbesondere kann die Steuer- und Auswerteeinrichtung 30, genauer der Prozessor 38 darin, nach Ermittlung der Wertdokumenteigenschaften ein Kriterium für den Gesamtzustand des Wertdokuments prüfen, in das wenigstens eine der Wertdokumenteigenschaften eingeht bzw. das von wenigstens einer der Wertdokumenteigenschaften abhängt. In das Kriterium können insbesondere weiter Referenzdaten zur Festlegung eines noch zulässigen Zustands des Wertdokuments eingehen, die vorgegeben und in dem Speicher 40 gespeichert sind. Der Gesamtzustand kann beispielsweise durch zwei Kategorien "noch umlauffähig" bzw. "verkehrsfähig" oder "zu vernichten" gegeben sein. In Abhängigkeit von dem ermittelten Zustand steuert die Steuer- und Auswerteeinrichtung 30, insbesondere der Prozessor 38 darin die Transporteinrichtung 18, genauer die Weiche 20, so an, daß das geprüfte Wertdokument entsprechend seinem ermittelten Gesamtzustand zur Ablage in das Ausgabefach 26 oder zur Vernichtung zu dem Shredder 28 transportiert wird.

Zur Bearbeitung von Wertdokumenten 12 werden in das Eingabefach 14 als Stapel oder einzeln eingelegte Wertdokumente 12 von dem Vereinzler 16 vereinzelt und vereinzelt der Transporteinrichtung 18 zugeführt, die die vereinzelten Wertdokumente 12 der Sensoranordnung 24 zuführt. Diese erfaßt wenigstens eine Eigenschaft der Wertdokumente 12, wobei Sensorsignale gebildet werden, die die Eigenschaft des Wertdokuments wiedergeben. Die Steuer- und Auswerteeinrichtung 30 erfaßt die Sensorsignale, ermittelt in Abhängigkeit von diesen einen Zustand des jeweiligen Wertdokuments und steuert in Abhängigkeit von dem Ergebnis die Weiche 20 so an, daß beispielsweise noch verwendbare Wertdokumente dem Ausgabefach 26 und zu vernichtende Wertdokumente dem Shredder 28 zur Vernichtung zugeführt werden.

Klebestreifen auf den Wertdokumenten 12 können beispielsweise mittels des Sensors 36, erkannt werden. Zur Charakterisierung des Zustands der Banknoten kann die Steuer- und Auswerteeinrichtung 30 hierzu beispielsweise die Anzahl der Klebestreifen oder die Gesamtlänge bzw. Gesamtfläche der Klebestreifen aus den Sensorsignalen des Sensors 36 ermitteln.

Zur Ermittlung des Gesamtzustands der Banknoten verwendet die Steuerund Auswerteeinrichtung 30 das bereits erwähnte Kriterium, in das wenigstens eine der Eigenschaften eingehen kann. Die einzelnen Werte können vorzugsweise beispielsweise in einem Kriterium verknüpft werden, beispielsweise mittels einer Linearkombination. Die Steuer- und Auswerteeinrichtung 30 vergleicht dann zur Ermittlung des Gesamtzustands der Banknoten die Linearkombination der den Zustand der Banknoten charakterisierenden Eigenschaften mit einem vorgegebenen Wert und entscheidet beispielsweise ob der Zustand der Banknoten gut oder schlecht ist, d. h. ob sie umlauffähig sind oder nicht. Dadurch wird erreicht, daß eine Banknote, die bereits eine erhebliche Verschmutzung aufweist, die aber für sich allein noch nicht dazu führen würde, daß der Zustand der Banknote als schlecht ermittelt werden würde, als schlecht ermittelt wird, wenn die Banknote zusätzlich z. B. auch nur wenige Flecken und/oder Risse usw. aufweist.

Der Ultraschallsensor 36, ein Sensor nach einer ersten bevorzugten Ausführungsform der Erfindung, ist in den Figuren 2 bis 5 teilweise genauer gezeigt.

Der Ultraschallsensor 36 verfügt über zwei bis auf eine Spiegelung an einer Ebene orthogonal zu deren Fläche gleich ausgebildete Halter 42 und 42', die jeweils auf einer Seite Leiterbahnen 44 aufweisen und in denen mit den Leiterbahnen 44 kontaktierte Ultraschallwandler 46 gehalten sind, sowie eine Ansteuer- und Signalverarbeitungseinrichtung 48, die über elektrische Verbindungen mit Steckverbindern 50 mit den Leiterbahnen 44 auf den Haltern 42, 42' und, in Fig. 2 nicht gezeigt, mit der Steuer- und Auswerteeinrichtung 30 zum Austausch von Signalen und zur Stromversorgung verbunden ist.

Die Halter 42 und 42' sind in ihrer Grundform plattenartig ausgebildet und mit ihren Plattenoberflächen 52 parallel zueinander angeordnet, so daß sich diese in einer Richtung orthogonal zu den Plattenoberflächen 52 decken. Durch einen zwischen den Haltern 42 und 42' gebildeten Erfassungsbereich 54 verläuft der Transportpfad 22, so daß durch den Erfassungsbereich transportierte Wertdokumente 12 mittels Ultraschall untersucht werden können.

Die Ultraschallwandler 46 in dem Halter 42 werden dazu als Ultraschallsender verwendet bzw. angesteuert, während die Ultraschallwandler 46 in dem Halter 42' als Empfänger für Ultraschall dienen, der durch eine Wertdokument 12 hindurchgetreten ist bzw. von diesem abgestrahlt wird. Die als Empfänger dienenden Ultraschallwandler geben bei Detektion von Ultraschall entsprechende Detektionssignale ab. Wie in Fig. 2 veranschaulicht, sind die Ultraschallwandler 46 so angeordnet, daß die zwischen Sendern und Empfänger gebildeten Ultraschallstrecken in guter Näherung orthogonal zu dem Wertdokument 12 bzw. den Plattenoberflächen 52 verlaufen.

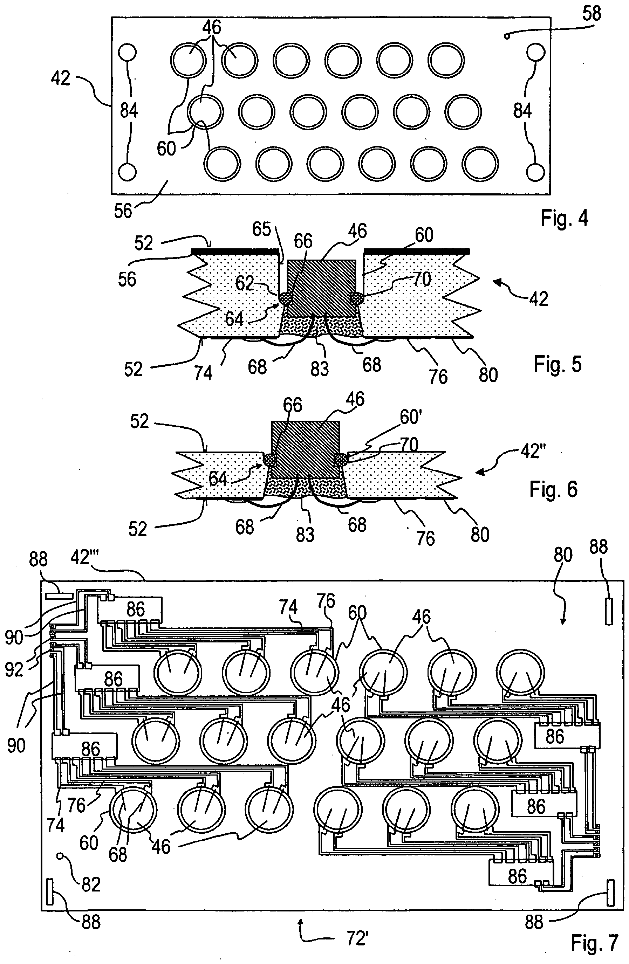

Der Halter 42, der wie bereits beschrieben bis auf die Spiegelung wie der Halter 42' ausgebildet ist, ist in den Figuren 3 und 4 genauer gezeigt.

Der Halter 42 ist in diesem Ausführungsbeispiel als Leiterplatte aus einem glasfaserverstärkten Kunstharz ausgebildet, die eine Dicke von 8 mm aufweist.

Weiter verfügt der Halter 42 an der in Fig. 4 veranschaulichten Seite bzw. Plattenoberfläche des Halters 42, im Folgenden der Einfachheit halber als Probenseite bezeichnet, über eine Abschirmschicht bzw. -kaschierung 56 aus einem elektrisch leitenden Material im Beispiel einem Metall wie Kupfer, vollflächig bedeckt. In dieser Abschirmschicht 56 ist ein Anschlußbereich 58 vorgesehen, über den die Abschirmschicht 56 mit einer Erdleitung verbunden werden kann. Die Probenseite des Halters ist die Seite des Halters auf der sich das zu untersuchende Wertdokument bei der Untersuchung befindet.

In den Halter 42 sind in drei zueinander versetzten Reihen in jeweils gleichem Abstand zueinander gleich ausgebildete, orthogonal zu den Plattenoberflächen 52 des Halters 42 verlaufende, Kanäle bildende Durchgangslöcher 60 ausgebildet, die zur Halterung der Ultraschallwandler 46 dienen. Durch die oben beschriebene Anordnung der Halter 42 und 42' zueinander fluchten die Löcher in den Haltern 42 mit denen der Löcher in dem Halter 42'.

Ein Querschnitt durch den Halter 42 im Bereich eines der Löcher ist schematisch in Fig. 5 gezeigt. Die anderen entsprechenden Abschnitte des Halters 42 sind gleich ausgebildet.

Jedes Loch 60 weist zwei Abschnitte mit unterschiedlichen Durchmessern auf, von denen der Abschnitt, der auf der Probenseite mündet, den größeren Durchmesser aufweist. Dadurch wird auf einer das Loch 56 bildenden inneren Oberfläche bzw. Wand 65 des Halters 42 in einem mittleren Abschnitt 62 eine Ausrichtstruktur 64 in Form einer ringförmig verlaufenden Schulter gebildet.

Der im Beispiel zylindrische Ultraschallwandler 46 verfügt entlang seines Umfangs über eine Haltenut 66. Weiter verfügt er an seiner der Probenseite abgewandeten Stirnseite über zwei elektrische Kontakte 68, im Beispiel Anschlußdrähte, zur direkten oder indirekten elektrischen Verbindung des Ultraschallwandlers 42 mit der Ansteuer- und Signalverarbeitungseinrichtung 48.

Der Ultraschallwandler 46 wird über ein Halteelement, im Beispiel einen Rundring 70, aus elastischem, vorzugsweise schalldämpfendem Material, das in die Haltenut 66 unter Vorspannung eingelegt ist, auf der Ausrichtstruktur bzw. Schulter 64 in einer durch die Lage der Schulter 64 und die Lage der Haltenut 66 relativ zu dem Halter 42 in einer vorgegebenen Richtung ausgerichtet, im Beispiel in den Figuren 2 bis 5 in Richtung wenigstens näherungsweise orthogonal zu den Plattenoberflächen 52. Dadurch ergibt sich eine entsprechende Ausrichtung der Empfangs- bzw. Sendecharakteristik (Empfindlichkeit) relativ zu dem Halter 42; das Maximum liegt näherungsweise in einer Richtung wenigstens näherungsweise orthogonal zu den Plattenoberflächen 52. Dadurch sind bei der gezeigten Anordnung der Halter 42 und 42' die Sende- und die Empfangscharakteristiken der Ultraschallwandler jeweils einer Ultraschallstrecke genau aufeinander ausgerichtet.

Die Ein- bzw. Auskopplung des Ultraschalls erfolgt im wesentlichen über eine Abstrahl- bzw. Empfangsfläche des Wandlers, die parallel der Oberfläche des Halters auf der Probenseite verläuft, d.h. in Fig. 3 nach oben angeordnet ist.

Auf der der Probenseite gegenüberliegenden Plattenoberfläche sind die Leiterbahnen 44 bzw. Leiterbahnstrukturen 72 in einer Leiterbahnschicht aus einem geeigneten Metall bzw. einer geeigneten Metalllegierung ausgebildet. In der Fig. 3 sind durch die schwarzen Linien die Bereiche der Oberfläche gekennzeichnet, in denen die Leiterbahnschicht nicht vorhanden ist und die daher isolierende Bereiche bilden. Von den Leiterbahnstrukturen 72 sind für jedes der Löcher 60, bzw. jedes der Bauteile 42 in Form der Ultraschallwandler, zwei Leiterbahnen 74 und 76 vorgesehen, die am Rand des jeweiligen Lochs über Kontaktierungsbereiche zum elektrischen Anschluß der Kontakte 68 des jeweiligen Bauteils 42, hier Ultraschallsensors, verfügen. In diesem Beispiel sind die Kontakte des Ultraschallwandlers mit den Leiterbahnen 74 und 76 durch Lötverbindungen kontaktiert.

An den anderen Enden der Leiterbahnen 74 und 76 sind ebenfalls Kontaktbereiche vorgesehen, in die Steckkontaktelemente 78, im Beispiel Buchsen, eingepreßt sind, in die entsprechende komplementäre Steckkontaktelemente in den Steckverbindern 50, im Beispiel, Steckkontaktstifte, einsteckbar sind. Durch diese Ausbildung des Halters 42 kann auf eine separate Anschlußleiterplatte verzichtet werden.

Die Leiterbahnen 74 und 76 sind für alle Ultraschallwandler etwa gleich kurz, so daß für alle Ultraschallwandler in etwa die gleiche Reduktion von Störsignalen auf die Leiterbahnen und damit darüber transportierten Signale erreicht werden kann.

Die leitfähigen Bereiche zwischen diesen Leiterbahnen bilden eine schichtförmige, zusammenhängende, elektrisch leitende Abschirmstruktur 80, die wie die Abschirmschicht 56 über einen Anschluß 82 für eine Erdleitung verfügt.

Die Leiterbahnen 74 und 76 sind daher auf der Oberfläche des Halters angeordnet, die von dem Wertdokument bei einer Untersuchung und von einer Abstrahl- oder Empfangsfläche des Bauteils abgewandt ist, d.h. auf der in Fig. 3 nach unten weisenden Oberfläche.

Die Haltenut 66 und der Abschnitt 62 bzw. die Ausrichtstruktur 64 in Verbindung mit der Dicke des Halters 42 sind so ausgebildet, daß der Ultraschallwandler 46 wenigstens teilweise, im Beispiel vollständig, in dem Loch 60 versenkt ist, so daß insbesondere auch seine elektrisch empfindlichen Abschnitte wie beispielsweise die Verbindungsleitungen zu seinem Piezoelement nahe den Kontakten 68 zum Anschluß des Ultraschallwandlers 46 in dem Halter 42 und damit, bis auf eine Versetzung in Richtung der Plattenoberflächen, zwischen der Abschirmschicht 56 und der Abschirmstruktur 80 angeordnet sind. Dadurch werden teilweise die Kontakte 68 und der Ultraschallwandler 42, insbesondere dessen elektrisch empfindlicher Abschnitt, gegenüber elektrischen und elektromagnetischen Feldern außerhalb des Halters 42 gut abgeschirmt.

Weiter sind die Ultraschallwandler 46 durch die Versenkung in den Löchern 60 gegen mechanische Einwirkung in einer Richtung parallel zu den Plattenoberflächen gut geschützt.

Darüber hinaus können die durch die Löcher gebildeten Kanäle auch die Abstrahl- bzw. Empfangscharakteristik der Ultraschallwandler bei geeigneter Ausbildung positiv beeinflussen.

Als optionales Merkmal ist zum Schutz der Kontakte 68 vor mechanischen und chemischen Einflüssen und zur weiteren mechanischen Stützung des Ultraschallwandlers 42 in dem Loch 60 der Bereich des Lochs 60 von dem Ultraschallwandler 42 bis zu der Plattenoberfläche 58 mit den Leiterbahnstrukturen mit einem polymeren Material 83 vergossen, das elektrisch isolierend und wenigstens soweit elastisch ist, daß es durch Temperaturschwankungen hervorgerufene Unterschied in den Dimensionsänderungen von Ultraschallwandlern und Löchern ausgleichen kann. Dieses Material ist der Übersichtlichkeit halber in Fig. 3 nicht gezeigt.

Der Halter 42 verfügt schließlich über Befestigungslöcher 84 zur Befestigung in der Wertdokumentbearbeitungsvorrichtung.

Ein weiterer Vorteil des Halters besteht darin, daß die Montage der Ultraschallwandler sehr einfach ist. Zur Montage des elektrischen Bauteils, im Beispiel des Ultraschallwandlers, wird dieser nach Überstreifen des Rundrings 70 und Bewegung desselben in die Haltenut 66 in das Loch 60 eingesetzt, so daß der Rundring 70 an der Ausrichtstruktur anliegt. Der Durchmesser des Lochs 42 und der Schulter 60 und der Durchmesser und Querschnitt des Rundrings 70 sind in Abhängigkeit von dem Durchmesser des Ultraschallwandlers 42 so gewählt, daß der Ultraschallwandler in der Lage im Klemmsitz gehalten ist. Danach werden die elektrischen Kontakte 68 des elektrischen Bauteils bzw. des Ultraschallwandlers 42 mit den entsprechenden Leiterbahnen 74 und 76 auf dem Halter 42 im Beispiel durch Löten kontaktiert. Die Kontaktierung kann sehr einfach erfolgen, da das jeweilige Bauteil bereits relativ zu dem Halter 42 und damit auch den Leiterbahnen 74 und 76 ausgerichtet und positioniert ist.

Danach wird der Bereich zwischen dem Ultraschallwandler 42 und der Plattenoberfläche mit den Leiterbahnen 44 mit dem Material 83 vergossen. Dabei dient der Rundring 70 zusammen mit der Schulter 60 als Abdichtung.

Diese Montage wird für beide Halter 42 und 42' und alle Ultraschallwandler 42 durchgeführt. Die Halter 42 und 42' werden dann mit ihren Abschirmschichten einander zu gerichtet parallel zueinander befestigt.

Ein zweites Ausführungsbeispiel in Fig. 6 unterscheidet sich von dem ersten Ausführungsbeispiel nur durch die Ausbildung der Halter 42 und 42'.

Wie in Fig. 6 am Beispiel des Halters 42" zu erkennen, verfügen die Halter nun nicht über die Abschirmschicht 56 und weisen eine geringere Dicke auf, so daß das elektrische Bauteil, im Beispiel die Ultraschallwandler 42 nur teilweise in dem Halter, aber ausgerichtet wie im ersten Ausführungsbeispiel gehalten ist. Alle anderen Merkmale, insbesondere auch der Halter, sind ansonsten gleich denen des ersten Ausführungsbeispiels. Auch die Montage erfolgt in gleicher Weise.

Ein drittes Ausführungsbeispiel in Fig. 7 unterscheidet sich von dem ersten Ausführungsbeispiel wiederum durch die Ausbildung des Halters 42''' mit den als Empfänger betriebenen Ultraschallwandlern und die Ausbildung der Ansteuer- und Signalverarbeitungseinrichtung 48'.

Die Ansteuer- und Signalverarbeitungseinrichtung 48' verfügt nun auf dem Halter 42''' mit den als Empfängern dienenden Ultraschallwandlern über Signalverarbeitungsschaltungen 86, mit denen jeweils drei Ultraschallwandler 42 elektrisch verbunden sind und die Verstärkungseinrichtungen zur Verstärkung der Signale der mit ihnen verbundenen Ultraschallwandler 42, Analog-/Digital-Wandler zur Digitalisierung der verstärkten Signale und eine Multiplexeinrichtung zur Übermittlung der digitalisierten verstärkten Signale von drei Ultraschallwandlern über eine Verbindung an einen weiteren, in den Figuren nicht gezeigten Teil der Ansteuer- und Signalverarbeitungseinrichtung 48' besitzt. Dieser Teil verfügt über Einrichtungen zur Verarbeitung der empfangenen Signale in der gleichen Art und Weise wie im ersten Ausführungsbeispiel. Die Ansteuer- und Signalverarbeitungseinrichtung 48' ist ansonsten wie die Ansteuer- und Signalverarbeitungseinrichtung 48 des ersten Ausführungsbeispiels ausgebildet.

Der Halter 42''' unterscheidet sich von dem Halter 42' bzw. 42 des ersten Ausführungsbeispiels daher nur durch die Ausbildung der Leiterbahnstrukturen 72' und durch die Ausbildung der Befestigungseinrichtungen, die nun statt der Befestigungslöcher 84 Schlitze 88 für Rastzungen umfassen, so daß der Halter einfach durch Verrasten befestigt werden kann.

Bei dem Halter 42''' sind nun die Reihen der Löcher 60 etwas weiter voneinander beabstandet als im ersten Ausführungsbeispiel, wobei nun Leiterbahnen 74' und 76' von jedem der Löcher 60 zu den Signalverarbeitungsschaltungen 86 verlaufen.

Darüber hinaus sind für jede der Signalverarbeitungsschaltungen 86 zwei zusätzliche Leiterbahnen 90 vorgesehen. Die Leiterbahnen 90 sind so ausgelegt, daß die nicht mit den Signalverarbeitungsschaltungen 86 verbundenen Enden von Leiterbahnen, die zu jeweils drei auf einer Seite des Halters angeordneten Signalverarbeitungsschaltungen 86 führen, nebeneinander angeordnet und mit eingepreßten Steckkontaktelementen 92 verbunden sind. Diese dienen zur Herstellung einer Steckverbindung mit komplementären Steckkontaktelementen eines Steckverbinders an einer Leitung die zu dem weiteren Teil der Ansteuer- und Signalverarbeitungseinrichtung 48' führt.

Diese Ausführungsform hat den Vorteil, daß die Signale der als Empfänger dienenden Ultraschallwandler unmittelbar auf dem Halter 42''' verstärkt und digitalisiert werden können, was das Signal-/Rauschverhältnis verbessert.

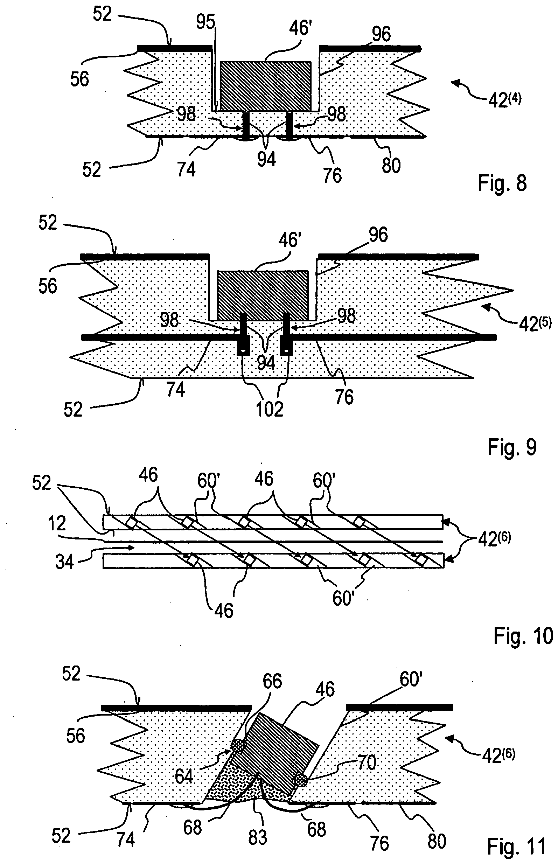

Ein vierter, nicht beanspruchter Ultraschallsensor in Fig. 8 unterscheidet sich von dem ersten Ausführungsbeispiel durch die Ausbildung der Halter 42⁽⁴⁾ und die Ultraschallwandler 46'. Weiterhin sind die Ultraschallwandler nicht eingegossen, obwohl dies prinzipiell möglich ist.

Die Ultraschallwandler 46' unterscheiden sich von den Ultraschallwandlern 46 dadurch, daß sie nun über Kontaktstifte 94 als elektrische Kontakte verfügen, und auf der Stirnseite, aus der die Kontaktstifte 94 austreten, eben ausgebildet sind.

Die Halter 42⁽⁴⁾ unterscheiden sich von den Haltern 42 und 42' durch eine reduzierte Dicke und dadurch, daß nun statt der Durchgangslöcher 60 zylindrische Ausnehmungen bzw. Sacklöcher 96 vorgesehen sind, in deren Boden 95 in einer Richtung orthogonal zu dem Boden 95 Durchgangsbohrungen 98 zu der Plattenoberfläche mit den Leiterbahnstrukturen 72 ausgebildet sind. Die Durchgangsbohrungen 98 führen in Kontaktbereiche der Leiterbahnen 74 und 76.

Ansonsten unterscheidet sich das Ausführungsbeispiel nicht von dem ersten Ausführungsbeispiel, so daß für die gleichen Elemente die gleichen Bezugszeichen verwendet werden und die Ausführungen zu dem ersten Ausführungsbeispiel entsprechend auch hier gelten.

Die Ultraschallwandler 46' können nun mit den Kontaktstiften 94 durch die Durchgangsbohrungen 98 gesteckt werden, bis sie mit ihrer Stirnseite auf der Oberfläche des Halters am Boden 95 der Sacklöcher 96 aufliegen. Dieser Abschnitt der Oberfläche des Halters bzw. der Ausnehmung dient somit der Ausrichtung der Ultraschallwandler 46' relativ zu dem Halter 42⁽⁴⁾. Im Beispiel verlaufen die Böden im wesentlichen parallel zu den Plattenoberflächen 52. Die Durchgangsbohrungen 98 dienen dagegen zur Positionierung in Richtung der Plattenoberfläche 52. Die Kontaktierung erfolgt auch hier durch Verlöten der durch die Durchgangsbohrungen 98 geführten Kontaktstifte 94 mit den entsprechenden Bereichen der Leiterbahnen 74 und 76. Damit ergibt sich neben den Vorteilen des ersten Ausführungsbeispiels eine besonders einfache Montage des Ultraschallelements.

Ein teilweise in Fig. 9 veranschaulichter fünfter nicht beanspruchter Ultraschallsensor unterscheidet sich von dem vierten Ultraschallsensor dadurch, daß die Halter 42⁽⁴⁾ durch Halter 42⁽⁵⁾ ersetzt sind. Alle anderen Elemente sind gleich, so daß für diese die gleichen Bezugszeichen verwendet werden und die Erläuterungen entsprechend auch hier gelten.

Der Halter 42⁽⁵⁾ unterscheidet sich von dem Halter 42⁽⁴⁾ dadurch, daß dieser mehrschichtig aufgebaut ist. Parallel zu den Plattenoberflächen 52 verläuft eine Schicht, in der die wie im ersten Ausführungsbeispiel ausgebildeten Leiterbahnstrukturen 72 angeordnet sind. In den Kontaktbereichen der Leiterbahnen sind in entsprechende Löcher Buchsen 102 eingepreßt, die mit den Durchgangsbohrungen 98 fluchten. Die Ultraschallwandler 46' können nun allein durch Einstecken kontaktiert werden, was die Montage nochmals vereinfacht.

Ein sechstes Ausführungsbeispiel in den Figuren 10 und 11 unterscheidet sich von dem ersten Ausführungsbeispiel nur durch die Ausbildung der Halter 42⁽⁶⁾, die sich von den Haltern 42 durch die Ausrichtung der Löcher 60' und damit der Ultraschallwandler 42 unterscheiden. Die Löcher 60' und damit die in diesen angeordneten Ultraschallwandler 46 sind nun gegenüber den Plattenoberflächen 52 geneigt. Die Kontaktierung mit Leiterbahnen der Halter bleibt unverändert. Alle anderen Merkmale sind entsprechend dem ersten Ausführungsbeispiel ausgebildet, so daß in den Figuren 10 und 11 dieselben Bezugszeichen verwendet werden und die Erläuterungen zu den unveränderten Merkmalen des ersten Ausführungsbeispiels auch hier gelten.

Diese Ausführungsform hat den Vorteil, daß zwischen den Ultraschallwandlern und dem zu untersuchenden Wertdokument keine stehenden Ultraschallwellen oder mehrfach reflektierten Ultraschallpulse auftreten können, so daß die Frequenz, mit der Untersuchungen durchgeführt werden können, erhöht werden kann. Auch sind so Messungen möglich, bei denen Ultraschall kontinuierlich gesendet werden kann.

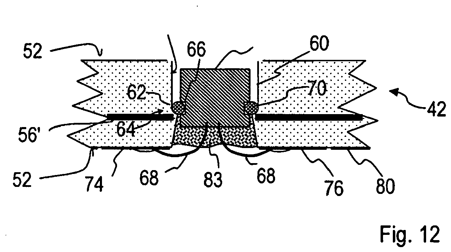

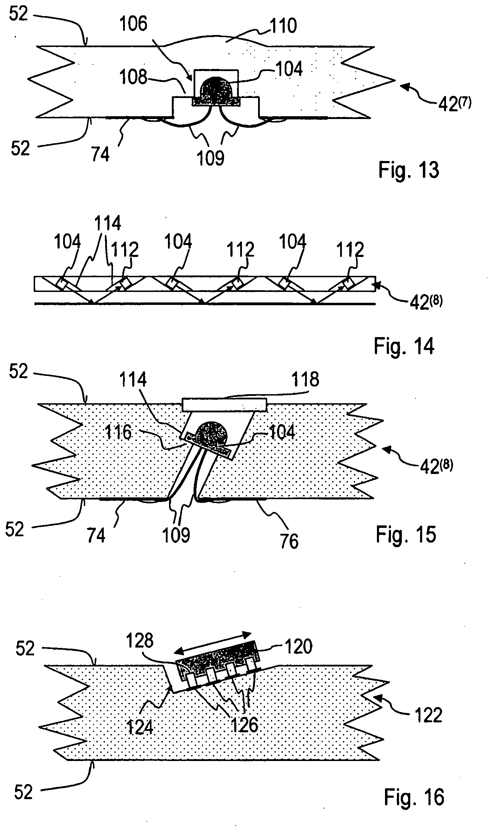

Ein weiteres Ausführungsbeispiel in Fig. 12 unterscheidet sich von dem Ausführungsbeispiel in Fig. 5 nur durch die Anordnung der leitfähigen Abschirmschicht 56', die nun innerhalb des Halters angeordnet ist. Alle anderen Teile des Sensors entsprechen denen in Fig. 3, so daß für diese die gleichen Bezugszeichen verwendet werden und die Ausführungen zu diesen auch hier gelten.

Bei der in der dem Halter 46 angeordneten Schicht 56' kann es sich insbesondere um eine Cu-Schicht handeln, die mit einem nicht gezeigten Anschluß für einen Masseanschluß verbunden ist.

## Patentansprüche

1. Sensor zur Untersuchung eines Wertdokuments (12) in einem Erfassungsbereich (54) des Sensors (34) mit
wenigstens einem elektrischen Bauteil (46; 46') zur Wandlung elektrischer Energie in Schallwellen zur Untersuchung des Wertdokuments (12) und/oder zur Detektion von Schallwellen von dem Wertdokument (12) unter Bildung von Detektionssignalen, das einen Ultraschallwandler (46) umfaßt, und
einem Halter (42; ...; 42⁽⁸⁾) für das Bauteil (46; 46'), der ein Loch (60; 60') zur wenigstens teilweisen Aufnahme des Bauteils (46; 46';) aufweist, in dem das elektrische Bauteil (46; 46') gehalten ist,
**dadurch gekennzeichnet,**
**dass** der Halter (42; ...; 42⁽⁸⁾) einstückig ausgebildet ist,
**dass** das Loch (60; 60') einen sich durch den Halter (42; ...; 42(8)) erstreckenden Kanal bildet, und
**dass** sich auf oder in dem Halter (42; ...; 42⁽⁸⁾) wenigstens eine Leiterbahn (74, 76) erstreckt, mit der wenigstens ein elektrischer Kontakt (68; 98) des elektrischen Bauteils (46; 46') kontaktiert ist.

2. Sensor nach Anspruch 1, bei dem der Halter (42; ...; 42(8)) in seiner Grundform plattenförmig ausgebildet ist.

3. Sensor nach einem der vorhergehenden Ansprüche, bei dem die Leiterbahn auf einer Oberfläche des Halters angeordnet ist, die von dem Wertdokument bei einer Untersuchung abgewandt ist.

4. Sensor nach einem der vorhergehenden Ansprüche, bei dem das Bauteil (46; 46') mittels wenigstens eines Oberflächenabschnitts einer das Loch (60; 60') bildenden Wand (65) und/oder einer Ausrichtstruktur (64) der Wand relativ zu dem Halter (42; ...; 42(8)) ausgerichtet ist.

5. Sensor nach Anspruch 4, bei dem der Oberflächenabschnitt (95) bzw. die Ausrichtstruktur (64) und das Bauteil (46; 46') so ausgebildet sind, daß das Bauteil (46; 46') mit einer Hauptabstrahlrichtung oder einer Hauptempfangsrichtung gegenüber der Oberfläche (52) des Halters (42; ...; 42(8)) geneigt ist.

6. Sensor nach Anspruch 4 oder 5, bei dem die Ausrichtstruktur (64) eine um das Loch (60; 60') umlaufende Schulter oder eine Nut an einer Innenwand des Loches aufweist.

7. Sensor nach einem der vorhergehenden Ansprüche, bei der das Loch (60; 60') rotationssymetrisch um eine in ihrer Lage relativ zu dem Halter (42; ...; 42(8)) vorgegebene Achse ausgebildet ist.

8. Sensor nach einem der vorhergehenden Ansprüche, bei dem das Loch (60; 60') gegenüber einer Oberfläche (52) des Halters (42; ...; 42(8)) geneigt ist.

9. Sensor nach einem der vorhergehenden Ansprüche, bei dem das Bauteil (46; 46') wenigstens teilweise in dem Loch (60; 60') eingegossen ist.

10. Sensor nach einem der vorhergehenden Ansprüche, bei dem an einer Oberfläche (52) des Halters (42; ...; 42(8)) oder in dem Halter eine elektrisch leitende Abschirmschicht (56; 56'; 80) ausgebildet ist.

11. Sensor nach Anspruch 12, bei dem die Abschirmschicht (56) an der Oberfläche (52) des Halters (42) ausgebildet und ein gegen elektrische oder elektromagnetische Felder empfindlicher Abschnitt des Bauteils (46; 46') in dem Loch (60; 60') angeordnet ist.

12. Sensor nach einem der vorhergehenden Ansprüche, bei dem das Bauteil (46; 46') mittels eines Drahtes (68) mit der Leiterbahn (74, 76) kontaktiert ist.

13. Sensor nach einem der vorhergehenden Ansprüche, der ein weiteres Bauteil (46; 46') zur Wandlung elektrischer Energie in Schallwellen zur Untersuchung des Wertdokuments (12) und/oder zur Detektion von Schallwellen von dem Wertdokument (12) unter Bildung von Detektionssignalen, aufweist und bei dem der Halter wenigstens ein weiteres Loch (60; 60'), in dem das weitere Bauteil (46; 46') wenigstens teilweise angeordnet ist, sowie eine weitere Leiterbahn (74; 76), mit der wenigstens ein elektrischer Kontakt (68; 98) des weiteren Bauteils (46; 46') kontaktiert ist, aufweist.

14. Sensor nach einem der vorhergehenden Ansprüche, bei dem das wenigstens eine Bauteil (46; 46') als Sender mit richtungsabhängiger Sendecharakteristik ausgebildet ist, und ein weiteres Bauteil (46; 46') als Empfänger mit richtungsabhängiger Empfangscharakteristik wenigstens teilweise in einem weiteren Loch in dem Halter angeordnet und mit einer weiteren Leiterbahn (74, 76) in oder auf dem Halter kontaktiert ist, wobei die Bauteile so relativ zueinander gehalten sind, daß der Empfänger bei Untersuchung eines Wertdokuments (12) wenigstens näherungsweise die höchste Intensität empfangen kann.

15. Sensor nach einem der vorhergehenden Ansprüche, bei dem auf dem Halter eine elektrische Schaltung (86) zur Ansteuerung des Bauteils (46; 46') oder zur Verarbeitung von Signalen des Bauteils (46; 46') angeordnet und mit der Leiterbahn (74; 76) verbunden ist.

16. Verfahren zur Montage eines elektrischen Bauteils (46; 46') zur Wandlung elektrischer Energie in Schallwellen zur Untersuchung des Wertdokuments (12) und/oder zur Detektion von Schallwellen von dem Wertdokument (12) unter Bildung von Detektionssignalen, das einen Ultraschallwandler (46) umfaßt, in einem Loch (60; 60') in einem einstückig ausgebildeten Halter, das einen sich durch den Halter (42; ...; 42(8)) erstreckenden Kanal bildet,
bei dem das Bauteil (46; 46') wenigstens teilweise in das Loch (60; 60') eingebracht wird und wenigstens ein elektrischer Kontakt (68; 98) des elektrischen Bauteils (46; 46') mit einer sich auf oder in dem Halter (42; ...; 42⁽⁸⁾) erstreckenden Leiterbahn (74, 76) kontaktiert wird.

## Claims

1. A sensor for examining a value document (12) in a detection range (54) of the sensor (34) having
at least one electrical component (46; 46') for converting electrical energy into sound waves for exami ni ng the value document (12) and/or for detecti ng sound waves from the value document (12), so as to generate detection signals, which comprises an ultrasonic converter (46), and
a holder (42; ...; 42⁽⁸⁾) for the component (46; 46') having a hole (60; 60') for accommodating at least partially the component (46; 46') in which the electrical component (46; 46') is held,
**characterized in that**
the holder (42; ...; 42⁽⁸⁾) is formed as a single piece, that the hole (60; 60') forms a channel extending through the holder (42; ...; 42⁽⁸⁾), and
on or in the holder (42; ...; 42⁽⁸⁾) there extends at least one conductor path (74, 76) with which at least one electrical contact (68; 98) of the electrical component (46; 46') is contacted.

2. The sensor according to claim 1, wherein the holder (42; ǔ ; 42⁽⁸⁾) in its basic form is formed in plate-shaped manner.

3. The sensor according to any of the preceding claims, wherein the conductor path is arranged on a surface of the holder that faces away from the value document during an examination.

4. The sensor accordi ng to any of the precedi ng claims, wherein the component (46; 46') is oriented relative to the holder (42; ǔ ; 42⁽⁸⁾) by means of at least one surface section of a wall (65) forming the hole (60; 60') and/or an orientation structure (64) of the wall.

5. The sensor according to claim 4, wherein the surface section (95) and/or the orientation structure (64) and the component (46; 46') are formed such that the component (46; 46') with a main emission direction or a main reception direction is inclined with respect to the surface (52) of the holder (42; ǔ ; 42⁽⁸⁾).

6. The sensor according to claim 4 or 5, wherein the orientation structure (64) has a shoulder extending circumferentially around the hole (60; 60') or a groove on an inside wall of the hole.

7. The sensor according to any of the preceding claims, wherein the hole (60; 60') is formed rotation-symmetrically around an axis predetermined in its position relative to the holder (42; ...; 42⁽⁸⁾).

8. The sensor according to any of the preceding claims, wherein the hole (60; 60') is inclined with respect to a surface (52) of the holder(42; ...; 42⁽⁸⁾).

9. The sensor according to any of the preceding claims, wherein the component (46; 46') is cast at least partially in the hole (60; 60').

10. The sensor according to any of the preceding claims, wherein on a surface (52) of the holder (42; ...; 42⁽⁸⁾) or in the holder an electrically conductive shielding layer (56; 56'; 80) is formed.

11. The sensor according to claim 12, wherein the shielding layer (56) is formed on the surface (52) of the holder (42) and a section of the component (46; 46') that is sensitive to electrical or electromagnetic fields is arranged in the hole (60; 60').

12. The sensor according to any of the preceding claims, wherein the component (46; 46') is contacted with the conductor path (74, 76) by means of a wire (68).

13. The sensor according to any of the preceding claims, having a further component (46; 46') for converting electrical energy into sound waves for examining the value document (12) and/or for detecti ng sound waves from the value document (12), so as to generate detection signals, and wherein the holder has at least one further recess (121) or one further hole (60; 60') in which the further component (46; 46') is arranged at least partially, as well as a further conductor path (74; 76) with which at least one electrical contact (68; 98) of the further component (46; 46') is contacted.

14. The sensor accordi ng to any of the precedi ng claims, wherein the at least one component (46; 46') is formed as an emitter with direction-dependent emission characteristic, and a further component (46; 46') as a receiver with direction-dependent receiving characteristic is arranged at least partially in a further recess (124) or boring in a further hole in the holder and is contacted with a further conductor path (74, 76) in or on the holder, wherein the components are held relative to each other in such a manner that upon examining a value document (12) the receiver can receive at least approximately the highest intensity.

15. The sensor according to any of the preceding claims, wherein an electrical circuit (86) for controlling the component (46; 46') or for processing signals of the component (46; 46') is arranged on the holder and connected to the conductor path (74; 76).

16. A method for mounting an electrical component (46; 46') for converting electrical energy into sound waves for exami ni ng the value document (12) and/or for detecti ng sound waves from the value document (12), so as to generate detection signals, which comprises an ultrasonic converter (46), in a hole (60; 60') in a holder formed as a single piece, said hole forming a channel extending trough the holder (42; ...; 42⁽⁸⁾),
wherein the component (46; 46') is inserted at least partially in the hole (60; 60') and at least one electrical contact (68; 98) of the electrical component (46; 46') is contacted with a conductor path (74, 76) extending on or in the holder (42; ...; 42⁽⁸⁾).

## Revendications

1. Capteur destiné à l'examen d'un document de valeur (12) dans une zone de saisie (54) du capteur (34), ayant
au moins un composant électrique (46; 46') pour la transformation d'énergie électrique en ondes acoustiques pour l'examen du document de valeur (12) et/ou pour la détection d'ondes acoustiques du document de valeur (12) avec constitution de signaux de détection, lequel comprend un transducteur ultrasonique (46), et
un support (42; ...; 42⁽⁸⁾) pour le composant (46; 46'), comportant un trou (60; 60') destiné au logement au moins partiel du composant (46; 46') et dans lequel le composant électrique (46; 46') est maintenu,
**caractérisé en ce**
**que** le support (42; ...; 42⁽⁸⁾) est réalisé en un seul tenant,
**que** le trou (60; 60') constitue un canal s'étendant à travers le support (42; ...; 42⁽⁸⁾), et
**que**, sur ou dans le support (42; ...; 42⁽⁸⁾), au moins une piste conductrice (74, 76) s'étend, avec laquelle au moins un contact électrique (68; 98) du composant électrique (46; 46') est en contact.

2. Capteur selon la revendication 1, dans lequel le support (42; ...; 42⁽⁸⁾) est, quant à sa forme de base, réalisé en forme de plaque.

3. Capteur selon une des revendications précédentes, dans lequel la piste conductrice est agencée sur une surface du support tournée à l'opposé du document de valeur lors d'un examen.

4. Capteur selon une des revendications précédentes, dans lequel le composant (46; 46') est aligné au moyen d'au moins une partie de surface (95) de la paroi (65) constituant le trou (60; 60') et/ou au moyen d'une structure d'alignement (64) de la paroi relativement au support (42; ...; 42⁽⁸⁾).

5. Capteur selon la revendication 4, dans lequel la partie de surface (95) ou la structure d'alignement (64) et le composant (46; 46') sont réalisés de telle façon que le composant (46; 46') est incliné dans une direction principale de rayonnement ou dans une direction principale de réception par rapport à la surface (52) du support (42; ...; 42⁽⁸⁾).

6. Capteur selon la revendication 4 ou 5, dans lequel la structure d'alignement (64) comporte un épaulement sur tout le pourtour du trou (60; 60') ou une rainure à une paroi intérieure du trou.

7. Capteur selon une des revendications précédentes, dans lequel le trou (60; 60') est réalisé à symétrie de révolution autour d'un axe prédéterminé quant à sa position par rapport au support (42; ...; 42⁽⁸⁾).

8. Capteur selon une des revendications précédentes, dans lequel le trou (60; 60') est incliné par rapport à une surface (52) du support (42; ...; 42⁽⁸⁾).

9. Capteur selon une des revendications précédentes, dans lequel le composant (46; 46') est au moins partiellement coulé dans le trou (60; 60').

10. Capteur selon une des revendications précédentes, dans lequel, à une surface (52) du support (42; ...; 42⁽⁸⁾) ou dans le support, une couche de blindage (56; 56'; 80) électroconductrice est réalisée.

11. Capteur selon la revendication 12, dans lequel la couche de blindage (56) est réalisée à la surface (52) du support (42) et une partie du composant (46; 46') sensible aux champs électriques ou électromagnétiques est agencée dans le trou (60; 60').

12. Capteur selon une des revendications précédentes, dans lequel le composant (46; 46') est, au moyen d'un fil (68), en contact avec la piste conductrice (74, 76).

13. Capteur selon une des revendications précédentes, lequel comporte un autre composant (46; 46') pour la transformation d'énergie électrique en ondes acoustiques pour l'examen du document de valeur (12) et/ou pour la détection d'ondes acoustiques du document de valeur (12) avec constitution de signaux de détection, et dans lequel le support comporte au moins un autre trou (60; 60') dans lequel l'autre composant (46; 46') est agencé au moins partiellement, ainsi qu'une autre piste conductrice (74; 76) avec laquelle au moins un contact électrique (68; 98) de l'autre composant (46; 46') est en contact.

14. Capteur selon une des revendications précédentes, dans le lequel le au moins un composant (46; 46') est réalisé en tant qu'émetteur à caractéristique de réception dépendant de la direction, et un autre composant (46; 46') est, en tant que récepteur à caractéristique d'émission dépendant de la direction, agencé au moins partiellement dans un autre trou dans le support et est un contact avec une autre piste conductrice (74, 76) dans ou sur le support, cependant que les composants sont maintenus de telle manière relativement les uns aux autres que le récepteur peut, lors d'un examen d'un document de valeur (12), recevoir au moins approximativement l'intensité la plus élevée.

15. Capteur selon une des revendications précédentes, dans le lequel, sur le support, un circuit électrique (86) est agencé pour la commande du composant (46; 46') ou pour le traitement de signaux du composant (46; 46') et est relié à la piste conductrice (74; 76).

16. Procédé de montage d'un composant électrique (46; 46') pour la transformation d'énergie électrique en ondes acoustiques pour l'examen du document de valeur (12) et/ou pour la détection d'ondes acoustiques du document de valeur (12) avec constitution de signaux de détection, lequel comprend un transducteur ultrasonique (46), dans un trou (60; 60') dans un support réalisé en un seul tenant qui constitue un canal s'étendant à travers le support (42; ...; 42⁽⁸⁾),
dans le lequel le composant (46; 46') est au moins partiellement inséré dans le trou (60; 60') et au moins un contact électrique (68; 98) du composant électrique (46; 46') est mis en contact avec une piste conductrice (74, 76) s'étendant sur ou dans le support (42; ...; 42⁽⁸⁾).
